# EUROPÄISCHE PATENTSCHRIFT

(11) **EP 3 374 986 B1**
(45) Veröffentlichungstag und Bekanntmachung des Hinweises auf die Patenterteilung: **04.09.2019**
(21) Anmeldenummer: 16797828.7
(22) Anmeldetag: 11.11.2016
(51) Int. Cl.: G09G 3/32, H01L 25/075, G06F 3/14, H01L 27/32, H01L 33/62

(54) **MODUL FÜR EINE VIDEOWAND**
MODULE FOR A VIDEO WALL
MODULE POUR MUR VIDÉO

(30) Priorität: 13.11.2015 DE 102015119653
(43) Veröffentlichungstag der Anmeldung: 19.09.2018
(73) Patentinhaber: OSRAM Opto Semiconductors GmbH, 93055 Regensburg (DE)
(72) Erfinder: MARTIN, Alexander, 93161 Sinzing (DE); SCHWARZ, Thomas, 93055 Regensburg (DE); SINGER, Frank, 93128 Regenstauf (DE); PLOESSL, Andreas, 93051 Regensburg (DE)
(74) Vertreter: Patentanwaltskanzlei WILHELM & BECK
(86) Internationale Anmeldenummer: PCT/EP2016/077489
(87) Internationale Veröffentlichungsnummer: WO 2017/081289

(56) Entgegenhaltungen:
- CN-A- 103 542 310
- US-A1- 2010 258 822
- US-A1- 2014 353 694
- US-A1- 2015 204 525

## Beschreibung

Die Erfindung betrifft ein Modul für eine Videowand gemäß Patentanspruch 1.

Im Stand der Technik sind Module für Videowände bekannt, bei denen eine Vielzahl von lichtemittierenden Leuchtchips angeordnet ist. Dabei ist es bekannt, mithilfe einer Matrixschaltung jeden einzelnen Leuchtchip anzusteuern. Dazu sind Stromleitungen in Reihen und Spalten angeordnet, wobei jeder Leuchtchip an einer Stromleitung einer Reihe und an einer Stromleitung einer Spalte angeschlossen ist.

Aus US 2015/0204525 A1 ist ein Modul für eine Videowand mit einem Träger und mit einer Vielzahl von Bildpixeln bekannt, wobei ein Bildpixel von wenigstens einem ersten und einem zweiten Leuchtchip gebildet wird. Jeder Leuchtchip weist einen ersten und einen zweiten elektrischen Anschluss auf. Der erste Leuchtchip eines Bildpixels ist mit dem ersten elektrischen Anschluss mit einer ersten Stromleitung verbunden. Der erste Leuchtchip des Bildpixels ist mit dem zweiten elektrischen Anschluss mit einer dritten Stromleitung verbunden. Der zweite Leuchtchip des Bildpixels ist mit dem ersten elektrischen Anschluss mit einer zweiten Stromleitung verbunden. Der zweite Leuchtchip des Bildpixels ist mit dem zweiten elektrischen Anschluss mit einer vierten Stromleitung verbunden. Die erste und die zweite Stromleitung sind in Form von extrem dünnen Golddrähten ausgebildet. Zudem weisen die Golddrähte Kontaktabschnitte auf.

Aus CN 103542310 A ist eine Herstellung einer Serienschaltung von Leuchtelementen bekannt, wobei eine Isolierschicht auf einem Träger vorgesehen ist, wobei die Isolierschicht Öffnungen aufweist.

Aus US 2014/0353694 A1 ist eine elektrische Schaltung zur Ansteuerung von Leuchtchips bekannt.

Aus US 2010/0258822 A1 ist ein Verfahren zur Herstellung einer lichtemittierenden Halbleitervorrichtung bekannt, wobei auf einem Substrat mehrere lichtemittierende Abschnitte beabstandet voneinander ausgebildet werden. Jeder lichtemittierende Abschnitt weist eine Laminatstruktur auf, in der eine Schichtanordnung aus Halbleiterschichten mit einer aktiven Schicht ausgebildet ist. Auf einer Oberseite ist eine zweite Elektrode vorgesehen, die mit einer Isolationsschicht bedeckt ist, wobei die Isolationsschicht eine Öffnung mittig über der zweiten Elektrode aufweist.

Die Aufgabe der Erfindung besteht darin, ein verbessertes Modul für eine Videowand bereitzustellen.

Die Aufgabe der Erfindung wird durch das Modul gemäß Patentanspruch 1 gelöst. Weitere Ausführungsformen des Moduls sind in den abhängigen Ansprüchen angegeben.

Ein Vorteil des beschriebenen Moduls besteht darin, dass ein Bildpixel mit zwei Leuchtchips vorgesehen ist, wobei für die zwei Leuchtchips vier verschiedene Stromleitungen für eine Spannungsversorgung vorgesehen sind. Auf diese Weise können unterschiedliche Spannungen für zwei Leuchtchips eines Bildpixels bereitgestellt werden. Somit können Leuchtchips mit den Spannungen versorgt werden, die die Leuchtchips für eine entsprechende Lichterzeugung benötigen.

In einer weiteren Ausführungsform weist ein Bildpixel drei Leuchtchips auf, wobei für die drei Leuchtchips eines Bildpixels drei verschiedene Spannungen bereitgestellt werden. Somit kann auch für mehr als zwei Leuchtchips eines Bildpixels die entsprechende benötigte Spannung bereitgestellt werden.

In einer weiteren Ausführungsform weist ein Bildpixel drei Leuchtchips auf, wobei zwei Leuchtchips mit der gleichen Spannung und ein dritter Leuchtchip mit einer unterschiedlichen Spannung versorgt werden.
Abhängig von der gewählten Ausführungsform können die Stromleitungen für die positive Stromversorgung der Leuchtchips in einer Ebene geführt werden, wohingegen die Stromleitungen für die negative Stromversorgung der Leuchtchips in einer zweiten Ebene geführt sind. Die Stromleitungen können in verschiedenen Ebenen eines Trägers, insbesondere einer Leiterplatte, angeordnet sein.

In einer weiteren Ausführungsform werden die verschiedenen Ebenen und die darin enthaltenen Stromleitungen über Durchkontaktierungen zu einer gemeinsamen Anschlussebene geführt. Auf diese Weise ist ein kompakter Aufbau des Moduls möglich.

In einer weiteren Ausführungsform sind die Leuchtchips in Reihen angeordnet, wobei jeweils wenigstens zwei Leuchtchips, insbesondere drei Leuchtchips einer Reihe zu einem Bildpixel zusammengefasst sind. Bei dieser Ausführungsform sind die erste und die zweite Stromleitung, die unterschiedliche positive Spannungen bereitstellen, an gegenüberliegenden Seiten einer Reihe angeordnet. Auf diese Weise kann ein kompakter Aufbau mit kurzen Stromleitungsstrecken erreicht werden.

In einer weiteren Ausführungsform sind die erste und die dritte Stromleitung in Form einer Flächenmetallisierung ausgeführt, wobei die Flächenmetallisierung Streifenabschnitte und Kontaktabschnitte aufweist, wobei ein Leuchtchip auf einem Kontaktabschnitt angeordnet ist, und wobei der Kontaktabschnitt eine kleinere Fläche als der Leuchtchip aufweist. Auf diese Weise wird ein ausreichend seitlicher Abstand zwischen Kontaktabschnitten verschiedener Leuchtchips bereitgestellt.

In einer weiteren Ausführungsform weisen die Leuchtchips auf der Seite, die dem Kontaktabschnitt zugeordnet ist, eine seitliche Abstufung auf. Auf diese Weise wird die Fläche des Leuchtchips, die dem Kontaktabschnitt zugeordnet ist, reduziert. Auch dadurch kann der seitliche Abstand zwischen benachbarten Kontaktabschnitten beziehungsweise den Kontaktbereichen benachbarter Leuchtchips vergrößert werden.

In einer weiteren Ausführungsform sind zwischen Kontaktabschnitten und benachbarten Leuchtchips elektrische Isolierungen vorgesehen. Dadurch wird die elektrische Isolierung benachbarter Kontaktabschnitte verbessert.

In einer weiteren Ausführungsform sind die Leuchtchips mithilfe elektrisch leitender Kontaktfilme mit den Kontaktabschnitten verbunden. Dadurch kann eine präzise Begrenzung der elektrisch leitenden Flächen erreicht werden. Somit kann ein gewünschter seitlicher Abstand zwischen benachbarten Kontaktabschnitten und damit die gewünschte elektrische Isolierung zwischen benachbarten Kontaktabschnitten zuverlässig erreicht werden.

Abhängig von der gewählten Ausführungsform kann ein Leuchtchip mithilfe einer Lotverbindung, insbesondere mit einer AuSn-Lotverbindung, wobei die Solidustemperatur der Lotverbindung über 260° C liegt, mit einem Kontaktabschnitt verbunden werden. Somit wird erreicht, dass bei einer späteren SMT-Montage des Moduls auf einer Leiterplatte, bei der einer Erwärmung des Moduls bis 260°C möglich ist, sich der Leuchtchip nicht von dem Träger bzw. dem Kontaktabschnitt löst. Weiterhin können die Leuchtchips mithilfe einer Reibschweißverbindung und/oder mithilfe einer Lötung mit einem Lotmaterial aus Gold, Zinn, Kupfer und Silber dem Kontaktabschnitt verbunden werden.

In einer Ausführungsform ist zwischen Kontaktabschnitten einer ersten und einer zweiten Stromleitung ein Isoliersteg vorgesehen. Dadurch wird die elektrische Trennung zwischen der ersten und der zweiten Stromleitung verbessert.

In einer Ausführungsform ist ein Leuchtchip mithilfe eines elektrisch leitfähigen Klebefilms auf einen Kontaktabschnitt einer Stromleitung befestigt. Dadurch wird wenig Platz beansprucht, der zudem genau definiert ist.

In einer Ausführungsform weist ein Leuchtchip auf einer Unterseite, die einem Kontaktabschnitt einer Stromleitung zugewandt ist, eine Abstufung auf, so dass eine Fläche der Unterseite des Leuchtchips kleiner ausgebildet ist. Dadurch ist der seitliche Platzbedarf reduziert.

In einer Ausführungsform ist wenigstens ein Leuchtchip mithilfe eines elektrisch isolierenden Klebstoffes auf einem Kontaktabschnitt mechanisch befestigt ist, wobei Spitzen eines metallischen Kontaktes des Leuchtchips den Klebstoff durchdringen und in elektrischen Kontakt mit dem Kontaktabschnitt stehen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei
- Fig.1: einen Ausschnitt eines elektrischen Ersatzschaltbildes eines Moduls für eine Videowand,
- Fig. 2: eine schematische Darstellung eines Ausschnittes eines elektrischen Ersatzschaltbildes einer weiteren Ausführungsform eines Moduls für eine Videowand,
- Fig. 3: einen Ausschnitt eines elektrischen Ersatzschaltbildes einer weiteren Ausführungsform eines Moduls für eine Videowand,
- Fig. 4: eine schematische Darstellung einer Steuerschaltung zum Ansteuern einzelner Leuchtchips eines Moduls,
- Fig. 5: eine schematische Darstellung einer Leiterbahnstruktur eines Trägers,
- Fig. 6: eine schematische Darstellung eines Ausschnittes einer Leiterbahnebene einer weiteren Ausführungsform eines Moduls,
- Fig. 7: eine schematische Seitenansicht eines Bildpixels,
- Fig. 8: eine schematische Darstellung einer weiteren Ausführungsform eines Bildpixels eines Moduls,
- Fig. 9: eine schematische Darstellung einer dritten Ausführungsform eines Bildpixels,
- Fig. 10: eine schematische Darstellung einer vierten Ausführungsform eines Bildpixels eines Moduls,
- Fig. 11: eine schematische Darstellung einer Leiterbahnstruktur eines Moduls,
- Fig. 12: einen vergrößerten Ausschnitt der Figur 11,
- Fig. 13: eine schematische Darstellung eines Teilausschnittes einer Leiterbahnstruktur einer weiteren Ausführungsform eines Moduls, und
- Fig. 14: eine schematische Darstellung eines Teilausschnittes eines Moduls mit einer Isolationsschicht.

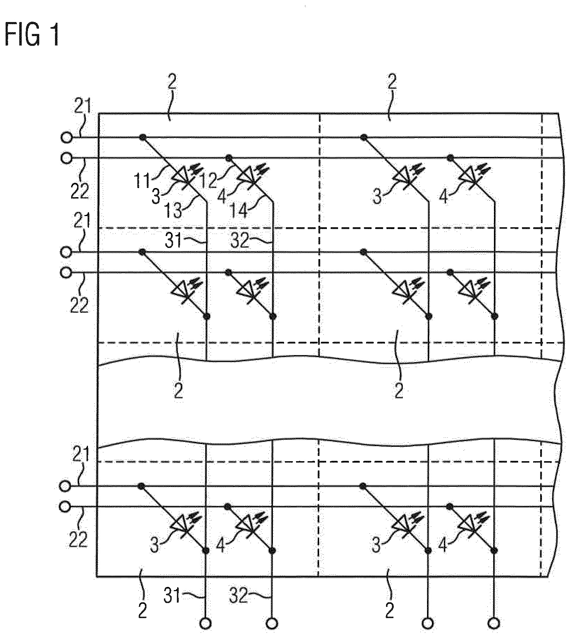

Fig. 1 zeigt in einer schematischen Darstellung ein elektrisches Ersatzschaltbild eines Moduls 1 mit Leuchtchips 3,4 für eine Videowand. Das Modul 1 weist eine Vielzahl von Bildpixeln 2 auf. Jeder Bildpixel 2 weist wenigstens einen Leuchtchip, insbesondere zwei oder mehr Leuchtchips 3,4 auf. In dem dargestellten Ausführungsbeispiel weist jeder Bildpixel 2 einen ersten und einen zweiten Leuchtchip 3,4 auf. Der erste Leuchtchip 3 eines Bildpixels 2 ist mit einem ersten Anodenanschluss 11 mit einer ersten Stromleitung 21 verbunden. Der zweite Leuchtchip 4 des Bildpixels 2 ist mit einer zweiten Anodenleitung 12 mit einer zweiten Stromleitung 22 verbunden. Ein erster Kathodenanschluss 13 des ersten Leuchtchips 3 ist mit einer dritten Stromleitung 31 verbunden. Der zweite Leuchtchip 4 des Bildpixels 2 ist mit einem zweiten Kathodenanschluss 14 mit einer vierten Stromleitung 32 verbunden.

Die dritte und die vierte Stromleitung 31, 32 sind auf Massepotential gelegt. Die erste und die zweite Stromleitung 21, 22 sind auf unterschiedlich hohe positive Potentiale gegenüber Masse gelegt. Beispielsweise kann die erste Stromleitung 21 auf 2,6 Volt gelegt sein. Die zweite Stromleitung 22 kann auf 3,7 Volt gelegt sein. Somit wird der erste Leuchtchip 3, der beispielsweise rotes Licht erzeugt, mit der benötigten Spannung von 2,6 Volt versorgt. Der zweite Leuchtchip 4, der beispielsweise blaues oder grünes Licht erzeugt, wird mit einer Spannung von 3,7 Volt versorgt. Das Modul 1 weist eine Vielzahl von Bildpixeln 2 auf, die identisch ausgebildet sind und deren Leuchtchips 3,4 an entsprechende Stromleitungen angeschlossen sind. Die Bildpixel können in Reihen und Spalten angeordnet sein. Zudem sind die ersten und die zweiten Stromleitungen in Reihen und die dritten und vierten Stromleitungen in Spalten angeordnet.

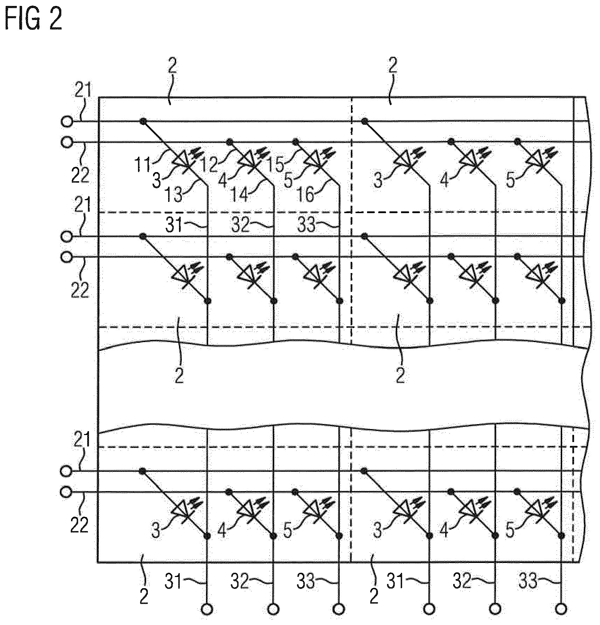

Fig. 2 zeigt eine weitere Ausführungsform, bei der ein Bildpixel 2 einen ersten Leuchtchip 3, einen zweiten Leuchtchip 4 und einen dritten Leuchtchip 5 aufweist. Der erste Leuchtchip 3 eines Bildpixels 2 ist an eine erste Stromleitung 21 angeschlossen, wie in Figur 1. Der zweite Leuchtchip 4 eines Bildpixels 2 ist wie in Figur 1 an eine zweite Stromleitung 22 angeschlossen. Der dritte Leuchtchip 5 ist mit einem dritten Anodenanschluss 15 mit der zweiten Stromleitung 22 verbunden. Der dritte Leuchtchip 5 ist zudem mit einem dritten Kathodenanschluss 16 mit einer fünften Stromleitung 33 verbunden. Somit werden der zweite und der dritte Leuchtchip 4, 5 mit der gleichen Spannung, insbesondere mit einer Spannung im Bereich zwischen 3 und 3,7 Volt versorgt. Die fünfte Stromleitung 33 ist ebenso wie die dritte und die vierte Stromleitung 31, 32 auf Masse gelegt. In dieser Art und Weise sind alle Bildpixel 2 des Moduls verschaltet. In diesem Ausführungsbeispiel stellt der zweite Leuchtchip 4 beispielsweise eine Leuchtdiode dar, die grünes Licht erzeugt. Der dritte Leuchtchip 5 stellt beispielsweise eine Leuchtdiode dar, die blaues Licht erzeugt. Die Bildpixel können in Reihen und Spalten angeordnet sein. Zudem sind die ersten und die zweiten Stromleitungen in Reihen und die dritten, die vierten und die fünften Stromleitungen in Spalten angeordnet.

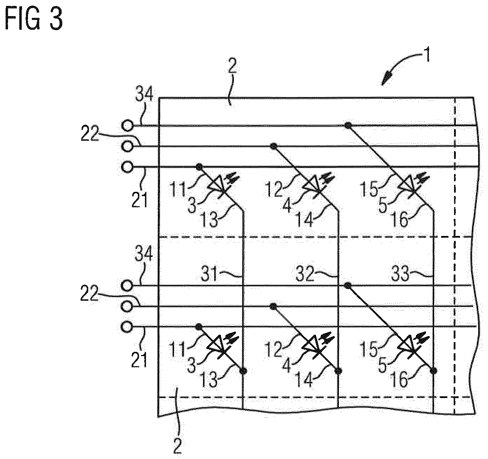

Abhängig von der gewählten Ausführungsform kann ein Modul 1 auch eine Vielzahl von Bildpixeln 2 aufweisen, die gemäß der Ausführungsform der Fig. 3 ausgebildet sind. Bei dieser Ausführungsform weist ein Bildpixel einen ersten, einen zweiten und einen dritten Leuchtchip 3, 4, 5 auf, wobei die Anodenanschlüsse 11, 12, 15 mit verschiedene Stromleitungen, d.h. mit einer ersten, einer zweiten und einer sechsten Stromleitung 21,22,34 verbunden sind. Somit kann bei dieser Ausführungsform jeder Leuchtchip 3, 4, 5 eines Bildpixels 2 mit unterschiedlichen Spannungen versorgt werden. Die Kathodenanschlüsse 13,14,16 der drei Leuchtchips 3,4,5 sind mit verschiedenen Stromleitungen 31, 32, 33 verbunden, wobei die Stromleitungen 31,32,33 an Masse angeschlossen sind.

Abhängig von der gewählten Ausführungsform können auch mehr als drei Leuchtchips eines Bildpixels mit den Anodenanschlüssen mit unterschiedlichen Stromleitungen mit unterschiedlichen Versorgungsspannungen versorgt werden.

Abhängig von der gewählten Ausführungsform können verschiedene Bildpixel mit verschiedener Anzahl von Leuchtchips in einem Modul kombiniert werden. Zudem können Gruppen von Leuchtchips eines Bildpixels mit gleichen Spannungen versorgt werden.

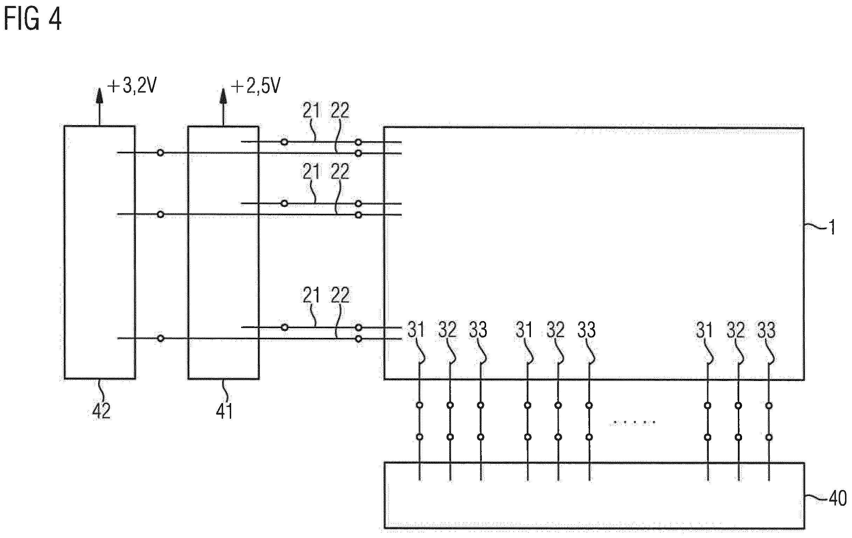

Fig. 4 zeigt in einer schematischen Darstellung eine Schaltungsanordnung zum Ansteuern der einzelnen Pixel eines Moduls 1, das gemäß Fig. 2 aufgebaut ist. Das Modul 1 steht mit einer Treiberschaltung 40 in Verbindung, die alle dritten, vierten und fünften Stromleitungen 31, 32, 33 der Bildpixel 2 mit Massepotential versorgt. Dabei können Schalter vorgesehen sein, die die einzelnen Stromleitungen mit Masse verbinden oder von der Masse isolieren.

Zudem ist einer erster Multiplexer 41 vorgesehen, der mit den ersten Stromleitungen 21 verbunden ist und die ersten Stromleitungen 21 der Bildpixel 2 mit einer ersten positiven Spannung beispielsweise mit 2,5 Volt versorgt. Weiterhin ist ein zweiter Multiplexer 42 vorgesehen, der mit den zweiten Stromleitungen 22 der Bildpixel verbunden ist und die zweiten Stromleitungen 22 mit einer zweiten positiven Spannung beispielsweise mit 3,6 Volt versorgt. Der erste und der zweite Multiplexer 41, 42 und die Treiberschaltung 40 sind ausgebildet, um abhängig von einer gewählten Ansteuerung einzelne Bildpixel und einzelne Leuchtchips des Moduls 1 anzusteuern.

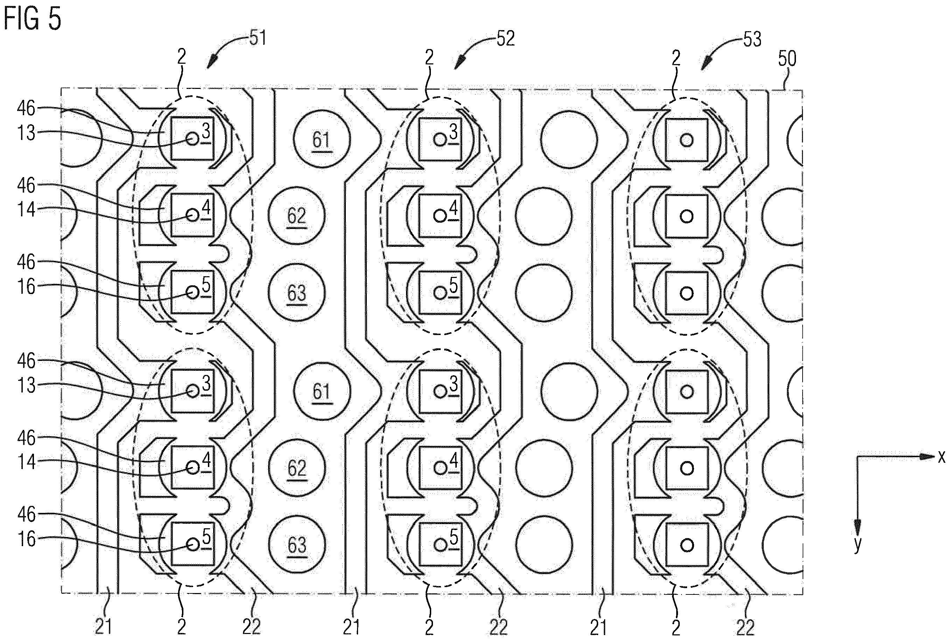

Fig. 5 zeigt in einer schematischen Darstellung eine Leitungsebene, die auf einem Träger 50 aufgebracht ist. Der Träger 50 kann beispielsweise in Form eines Substrates oder in Form einer Leiterplatte ausgebildet sein. Auf dem Träger 50 sind in einer ersten, in einer zweiten und in einer dritten Reihe 51, 52, 53 Leuchtchips 3, 4, 5 angeordnet. Die Reihen sind parallel zueinander angeordnet. Jeweils drei Leuchtchips 3, 4, 5, die in einer Reihe angeordnet sind, sind jeweils zu einem Bildpixel 2 zusammengefasst. Abhängig von der gewählten Ausführung können auch Bildpixel verschiedener Reihen zu einem Bildpixel zusammengefasst sein. Zudem kann jeder Bildpixel auch mehr oder weniger Leuchtchips umfassen. Jeder Bildpixel 2 umfasst in dieser Ausführung einen ersten, einen zweiten und einen dritten Leuchtchip 3, 4, 5. Die Bildpixel sind in Zeilen senkrecht zu den Reihen angeordnet. Der erste Leuchtchip 3 kann beispielsweise rotes Licht, der zweite Leuchtchip 4 grünes Licht und der dritte Leuchtchip 5 blaues Licht abgeben.

In der dargestellten Ausführungsform sind die Leuchtchips 3,4,5 in Form von vertikalen Leuchtchips ausgebildet, wobei auf einer Unterseite eines Leuchtchips 3,4,5 ein Anodenanschluss und auf einer Oberseite ein Kathodenanschluss 13,14,16 ausgebildet ist. In der dargestellten Ausführungsform ist jeweils auf einer linken Seite einer Reihe 51, 52, 53 eine erste Stromleitung 21 ausgebildet. Auf einer rechten Seite einer Reihe ist jeweils eine zweite Stromleitung 22 angeordnet. Zudem sind in der dargestellten Ausführungsform zwischen einer zweiten Stromleitung 22 und einer benachbarten ersten Stromleitung 21 Durchkontaktierungen 61, 62, 63 vorgesehen. Die Durchkontaktierungen können in eine tiefere Ebene des Trägers 50 oder auf eine Unterseite des Trägers 50 führen. Die erste und die zweite Stromleitungen 21,22 sind in Form von metallischen Leiterbahnen ausgebildet. In der dargestellten Ausführungsform sind die Leuchtchips 3, 4, 5 mit einer Unterseite, das heißt mit den Anodenanschlüssen, mit der entsprechenden ersten Stromleitung 21 oder der entsprechenden zweiten Stromleitung 22 verbunden. Dazu sind elektrisch leitende Schichten 46, insbesondere elektrisch leitende Klebeschichten vorgesehen. Abhängig von der gewählten Ausführungsform können die Anodenanschlüsse auch auf der Oberseite und die Kathodenanschlüsse auf der Unterseite der Leuchtchips 3,4,5 angeordnet sein.

In einer weiteren Ausführungsform sind die Anodenanschlüsse und/oder die Kathodenanschlüsse der Leuchtchips 3, 4, 5 aus einem metallischen Material mit einer rauen Oberfläche mit Spitzen oder mit einer unebenen Oberfläche ausgebildet. Die Unterseiten der Leuchtchips 3, 4, 5 mit den Anodenanschlüssen und/oder mit den Kathodenanschlüssen sind mithilfe elektrisch isolierender Klebstoffschichten auf entsprechenden Kontaktabschnitten 81, 82, 83 der Leiterbahnen mechanisch befestigt. Die rauen bzw. unebenen Oberfläche der Anodenanschlüsse und/oder der Kathodenanschlüsse sind dem jeweiligen Kontaktabschnitt 81,82,83 zugeordnet, wobei wenigstens einzelne Spitzen oder ein Teil der Oberfläche des Anodenanschlusses und/oder des Kathodenanschlusses den elektrisch isolierenden Klebstoff durchdringen und in elektrischen Kontakt mit dem zugeordneten Kontaktabschnitt steht.

In einer weiteren Ausführungsform können sowohl der Anodenanschluss als auch der Kathodenanschluss auf der Unterseite eines Leuchtchips 3,4,5 angeordnet sein. Bei dieser Ausführungsform ist sowohl für die Kontaktierung des Anodenanschlusses als auch die Kontaktierung des Kathodenanschlusses ein entsprechender Kontaktabschnitt auf dem Träger vorgesehen. Zudem sind bei dieser Ausführung der Anodenanschluss eines Leuchtchips mit einem ersten Kontaktabschnitt und der Kathodenanschluss des Leuchtchips mit einem zweiten Kontaktabschnitt elektrisch leitend verbunden. Die elektrisch leitende Verbindung kann über elektrisch leitende Kleber oder über Lotmaterial erfolgen. Zudem kann die elektrisch leitende Verbindung auch über elektrisch isolierende Kleber und Anodenanschlüsse und Kathodenanschlüsse mit unebenen Oberflächen bzw. rauen Oberflächen mit Spitzen erfolgen, die den isolierenden Kleber durchdringen und die zugeordneten Kontaktabschnitte kontaktieren.

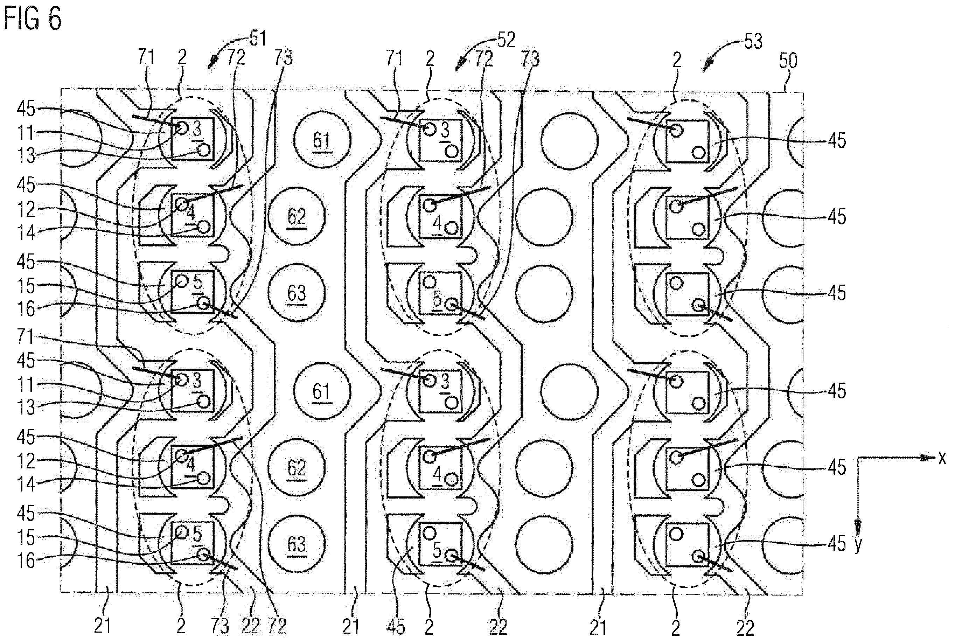

Fig. 6 zeigt eine weitere Ausführungsform, bei der die Anordnung der Stromleitungen 21,22 und der Leuchtchips 3,4,5 der Bildpixel 2 der Figur 5 entspricht, wobei jedoch die Leuchtchips 3, 4, 5 als horizontale Leuchtdioden ausgebildet sind. Bei horizontalen Leuchtdioden sind sowohl die Anodenanschlüsse 11, 12, 15 als auch die Kathodenanschlüsse 13, 14, 16 auf der Oberseite ausgebildet. Somit müssen in dieser Ausführungsform auch die Anodenanschlüsse 11, 12, 15 über Leitungsverbindungen 71, 72, 73 mit den ersten beziehungsweise den zweiten Stromleitungen 21, 22 verbunden werden. Die Leitungsverbindungen können beispielsweise in Form von Bonddrähten ausgebildet sein. Beispielsweise kann ein Leuchtchip aus Al-GaInP ausgebildet sein, der auf einem Träger aus Saphir angeordnet ist. Zudem kann es bei einem Leuchtchip mit einem elektrisch leitenden Substrat vorteilhaft sein, dass zwischen den Unterseiten der Leuchtchips 3, 4, 5 und den darunter angeordneten Stromleitungen 21, 22 eine elektrische Isolierung ausgebildet ist. Diese kann beispielsweise in Form von elektrisch isolierenden Klebeschichten 45 ausgebildet sein. Mithilfe der Klebeschichten können die Leuchtchips 3, 4, 5 mechanisch mit dem Träger 50 verbunden sein. Weiterhin sind weitere elektrische Leitungsverbindungen zwischen den Kathodenanschlüssen 13,14,16 und den dritten, vierten und fünften Stromleitungen erforderlich. Dazu kann eine Durchkontaktierung 61,62,63 verwendet werden, da die dritten, vierten und fünften Stromleitungen in einer anderen Ebene als die erste und die zweite Stromleitung 21,22 angeordnet sind. Diese sind aber in der Figur 6 für eine bessere Übersicht nicht dargestellt.

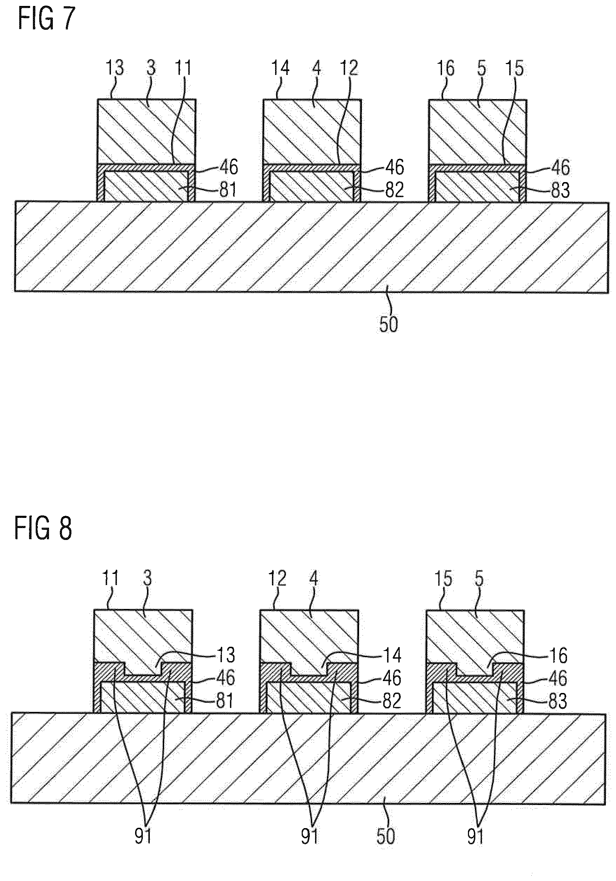

Fig. 7 zeigt in einer schematischen Seitenansicht einen Bildpixel einer ersten Ausführungsform, wobei ein erster Kontaktabschnitt 81 einer ersten Stromleitung 21, ein zweiter Kontaktabschnitt 82 einer zweiten Stromleitung 22 und ein dritter Kontaktabschnitt 83 der zweiten Stromleitung 22 dargestellt sind. Die Leuchtchips 3, 4, 5 sind in dieser Darstellung als vertikale Leuchtdioden ausgebildet, wobei auf der Unterseite eines Leuchtchips 3,4,5 ein Anodenanschluss 11,12,15 vorgesehen ist. Somit ist ein Anodenanschluss 11, 12, 15 der Leuchtchips 3, 4, 5 mit dem entsprechenden Kontaktabschnitt 81, 82, 83 elektrisch leitend verbunden. Dazu sind beispielsweise elektrisch leitende Schichten 46, wie z.B. Lotpads aus eine Lotpaste vorgesehen, die zwischen den Unterseiten der Leuchtchips 3, 4, 5 mit den Anodenanschlüssen und den Oberseiten der Kontaktabschnitte 81, 82, 83 ausgebildet sind. Die Lotpasten können beispielsweise aufgestempelt oder aufgedruckt werden. Zudem können elektrisch leitende Kleber, insbesondere druckbare Kleber zur Ausbildung der elektrisch leiten Verbindung zwischen den Anodenanschlüssen der Leuchtchips und den Kontaktabschnitten vorgesehen sein. Abhängig von der gewählten Ausführungsform können die Kontaktabschnitte 81, 82, 83 wenigstens in einer Richtung oder in beiden Richtungen die gleich große Fläche oder eine kleinere Fläche als die Leuchtchips 3, 4, 5 aufweisen.

Dadurch wird ein relativ großer seitlicher Abstand zwischen den Kontaktabschnitten 81, 82, 83 erreicht. Somit kann eine relativ gute elektrische Isolierung bei geringem Platzbedarf bereitgestellt werden.

In einer weiteren Ausführungsform können die Kontaktabschnitte 81, 82, 83 wenigstens in einer Richtung oder in beiden Richtungen eine größere Fläche als die Leuchtchips 3, 4, 5 aufweisen. Insbesondere kann ein Kontaktabschnitt für zwei oder mehr Leuchtchips vorgesehen sein.

Zudem können die vertikalen Leuchtchips auch auf der Unterseite Kathodenanschlüsse und auf der Oberseite Anodenanschlüsse aufweisen.

Fig. 8 zeigt in einer schematischen Seitenansicht eine weitere Ausführungsform eines Bildpixels, wobei bei dieser Ausführungsform die Leuchtchips 3, 4, 5 auch als vertikale Leuchtdioden ausgebildet sind, wobei bei dieser Ausführungsform die Kathodenanschlüsse 13,14,16 auf der Unterseite und die Anodenanschlüsse auf der Oberseite ausgebildet sind. Zudem weisen in dieser Ausführungsform die Leuchtchips 3, 4, 5 auf der Unterseite, das heißt auf der Seite, auf der der Kathodenanschluss 13,14,16 ausgebildet ist, eine Abstufung 91 auf, so dass die Fläche, mit der die Leuchtchips 3, 4, 5 auf den Kontaktabschnitten 81, 82, 83 aufliegen, kleiner ist als die Fläche der Kontaktabschnitte 81, 82, 83. Zudem kann durch die Abstufungen 91 elektrisches Kontaktmaterial aufgenommen werden. Auch dadurch wird verhindert, dass elektrisches Kontaktmaterial seitlich zu benachbarten Kontaktabschnitten bei der Montage der Leuchtchips geschoben wird.

Zudem können die vertikalen Leuchtchips bei dieser Ausführungsform auch auf der Unterseite die Kathodenanschlüsse und auf der Oberseite die Anodenanschlüsse aufweisen.

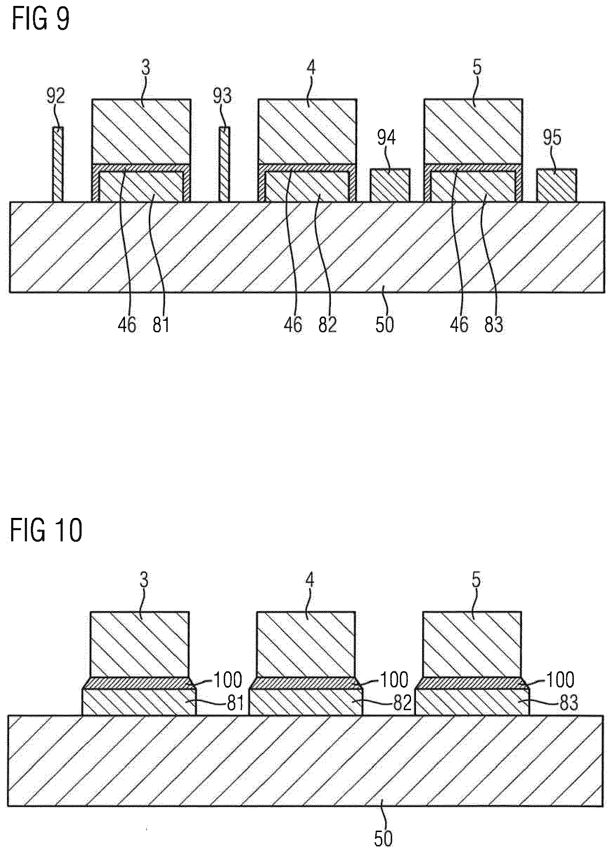

Fig. 9 zeigt eine weitere schematische Darstellung einer Ausführungsform eines Bildpixels, der gemäß Fig. 7 ausgebildet ist, wobei jedoch zwischen den Kontaktabschnitten 81, 82, 83 jeweils ein Isolationssteg 92,93,94,95 angeordnet ist. Der Isolationssteg kann aus einem elektrisch isolierenden Material, wie beispielsweise fotolithographisch strukturierbarem Epoxy (SU8), gebildet sein. Durch die Anordnung der Isolierstege wird eine verbesserte seitliche elektrische Isolierung erreicht.

Fig. 10 zeigt eine weitere schematische Darstellung einer Ausführungsform eines Bildpixels, bei dem die Leuchtchips 3, 4, 5 mithilfe von elektrisch leitenden Filmen 100 mit den Kontaktabschnitten 81, 82, 83 elektrisch kontaktiert sind. Durch die Verwendung von elektrisch leitenden Filmen ist eine sichere Begrenzung der elektrischen Bereiche seitlich zwischen Kontaktabschnitten 81, 82, 83 gegeben.

Abhängig von der gewählten Ausführungsform können auch Isolierkleber zur Montage der Leuchtchips insbesondere bei der Ausbildung der Leuchtchips in Form von horizontalen Leuchtdioden verwendet werden. Dabei ist jedoch darauf zu achten, dass trotzdem ein elektrischer Kontakt zwischen dem Anodenanschluss bzw. dem Kathodenanschluss und dem zugeordneten Kontaktabschnitt hergestellt wird.

Zudem können abhängig von der gewählten Ausführungsform die Leuchtchips mit einem Lotmetall z.B. mit einem heißen Bestückungskopf auf einen vorgewärmten Träger mit Stromleitungen auf die entsprechenden Kontaktabschnitte der Stromleitungen aufgepresst und verlötet werden.

Zudem kann abhängig von der gewählten Ausführungsform der elektrische Kontakt zwischen den Kontaktabschnitten 81, 82, 83 und den Anodenanschlüssen der Leuchtchips 3, 4, 5 mithilfe einer Reibschweißverbindung beispielsweise unter Verwendung von einer Goldfläche auf der Seite des Leuchtchips und einer Goldfläche auf dem Kontaktabschnitt erreicht werden.

Weiterhin können die Leuchtchips mit einer Lotverbindung, insbesondere mit einer AuSn-Lotverbindung mit den Kontaktabschnitten verbunden sein, wobei eine Solidustemperatur der Lotverbindung über 260° C liegt. Damit ist die Lotverbindung bis 260°C fest und verflüssigt sich nicht. Erst über einer Temperatur von 260°C beginnt die Lotverbindung weich und flüssig zu werden. Dadurch wird erreicht, dass bei einer späteren SMT-Montage des Moduls auf einer Leiterplatte, bei der einer Erwärmung des Moduls bis 260°C möglich ist, sich die Leuchtchips nicht von dem Träger bzw. den Kontaktabschnitten lösen.

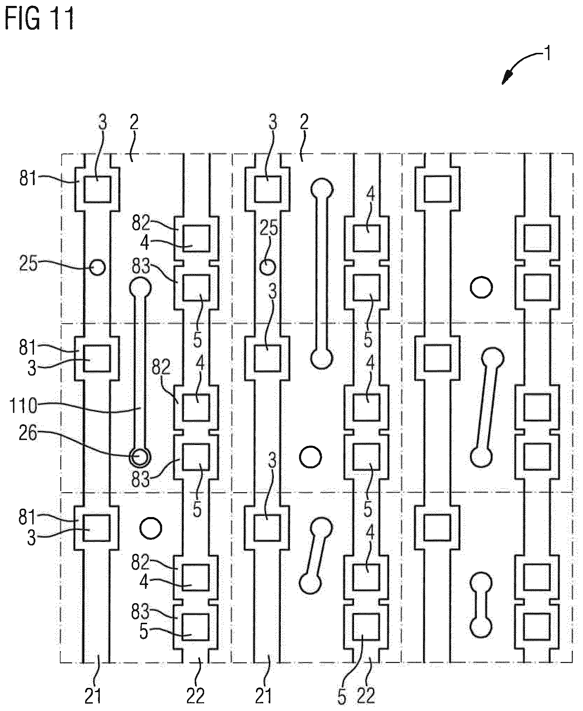

Fig. 11 zeigt in einer schematischen Darstellung einen Ausschnitt eines Moduls 1, wobei auf einem Träger 50 mehrere Bildpixel 2 angeordnet sind. Die Bildpixel 2 sind in einem Raster angeordnet das mit gestrichelten Linien angedeutet ist. Jedes Bildpixel 2 weist drei Leuchtchips 3,4,5 auf, die über eine erste und eine zweite Stromleitung 21, 22 mit positiven Spannungen versorgt werden. Die Leuchtchips sind als vertikale Leuchtdioden ausgebildet, wobei auf der Unterseite die Anodenanschlüsse und auf der Oberseite die Kathodenanschlüsse angeordnet sind. Die Anodenanschlüsse sind mit den Kontaktabschnitten der Stromleitungen verbunden. Die elektrische Verbindung der Kathodenanschlüsse ist nicht im Detail dargestellt. Die ersten und die zweiten Stromleitungen 21, 22 sind parallel nebeneinander angeordnet. Zudem sind mehrere Paare von ersten und zweiten Stromleitungen 21, 22 nebeneinander angeordnet. Auf der ersten Stromleitung 21 sind erste Kontaktabschnitte 81 angeordnet, auf denen erste Leuchtchips 3 angeordnet sind. Auf der zweiten Stromleitung 22 sind zweite und dritte Kontaktabschnitte 82,83 angeordnet, auf denen jeweils ein zweiter beziehungsweise ein dritter Leuchtchip 4, 5 angeordnet ist. Ein Bildpixel 2 weist einen ersten, einen zweiten und einen dritten Leuchtchip 3, 4, 5 auf. Die Bildpixel 2 sind schematisch in Form von umrandeten Quadraten dargestellt. Abhängig von der gewählten Ausführungsform kann jeder Bildpixel 2 auch mehr oder weniger Leuchtchips aufweisen.

Zwischen einer ersten und zweiten Stromleitung 21, 22, die in dem dargestellten Ausführungsbeispiel in Form von metallischen Leiterbahnen ausgebildet sind, ist eine Umverdrahtungsleiterbahn 110 vorgesehen. Die Umverdrahtungsleiterbahn 110 wird dazu verwendet, um die Kathodenanschlüsse der Leuchtchips mit Massepotential zu versorgen. Die einzelnen Leitungsverbindungen sind nicht explizit dargestellt. Weiterhin weist die erste Stromleitung 21 eine erste Durchkontaktierung 25 auf. Die erste Durchkontaktierung 25 ist entweder nach oben oder nach unten in den Träger 50 oder auf eine Unterseite des Trägers 50 zu einer weiteren Verdrahtungsebene geführt. Die Umverdrahtungsleiterbahn 110 weist eine zweite Durchkontaktierung 26 auf, die entweder nach oben oder nach unten zu einer weiteren Verdrahtungsebene geführt ist.

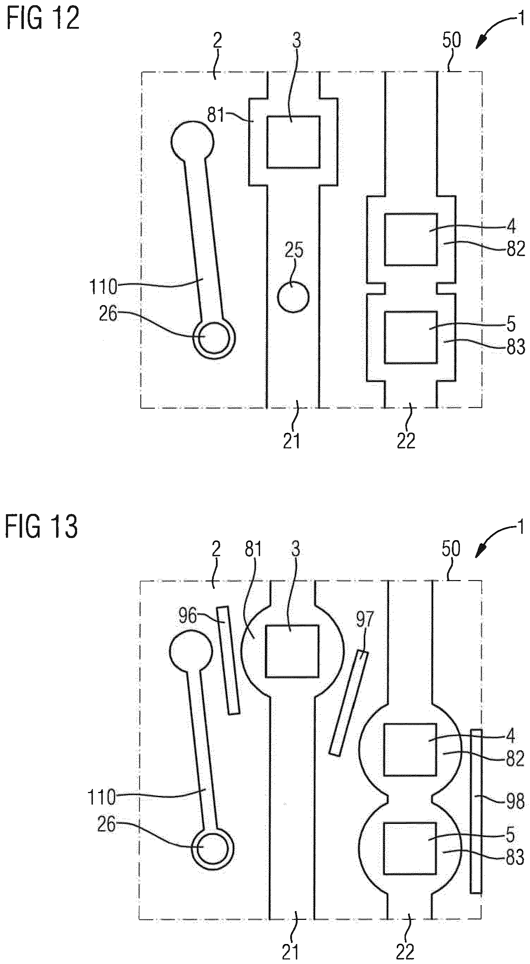

Fig. 12 zeigt einen Bildpixel 2 einer weiteren Ausführungsform eines Moduls 1 für eine Videowand, der im Wesentlichen gemäß den Bildpixeln 2 der Fig. 11 aufgebaut ist, wobei jedoch in dieser Ausführungsform die Umverdrahtungsleiterbahn 110 nicht zwischen der ersten und der zweiten Stromleitung 21, 22 angeordnet ist, sondern die erste Stromleitung 21 zwischen der Umverdrahtungsleiterbahn 110 und der zweiten Stromleitung 22 angeordnet ist.

Fig. 13 zeigt eine weitere Ausführungsform eines Bildpixels 2 eines Moduls 1 für eine Videowand, der im Wesentlichen gemäß dem Bildpixel der Fig. 11 ausgebildet ist. Zudem sind jedoch ein fünfter, ein sechster und ein siebter Isoliersteg 96, 97, 98 ausgebildet. Der fünfte Isoliersteg 96 ist zwischen der Umverdrahtungsleiterbahn 110 und dem ersten Kontaktabschnitt 81 angeordnet. Dabei erstreckt sich der fünfte Isoliersteg 96 über die gesamte Länge des ersten Kontaktabschnittes 81. Auf diese Weise wird eine verbesserte elektrische Isolierung zwischen der Umverdrahtungsleiterbahn 110 und dem ersten Kontaktabschnitt 81 erreicht. Weiterhin ist der sechste Isoliersteg 97 zwischen dem ersten Kontaktabschnitt 81 und dem zweiten Kontaktabschnitt 82 angeordnet. Auf diese Weise wird eine verbesserte elektrische Isolierung zwischen dem ersten und dem zweiten Kontaktabschnitt 81, 82 erreicht. Zudem ist angrenzend an einen Randbereich des Bildpixels 2 der siebte Isoliersteg 98 ausgebildet. Der siebte Isoliersteg 98 erstreckt sich über die Bereiche des zweiten und des dritten Kontaktabschnittes 82, 83. Angrenzend an den dargestellten Bildpixel ist ein weiterer gleich ausgebildeter Bildpixel vorgesehen. Somit verbessert der siebte Isoliersteg 98 die elektrische Isolation zwischen dem zweiten und dem dritten Kontaktabschnitt 82, 83 des dargestellten Bildpixels und der Umverdrahtungsleiterbahn 110 des benachbarten Bildpixels. Die in den Figuren 11 bis 13 dargestellten Leuchtchips 3, 4, 5 sind als vertikale Leuchtchips ausgebildet, wobei die Anodenanschlüsse auf der Unterseite und die Kathodenanschlüsse auf der Oberseite ausgebildet sind.

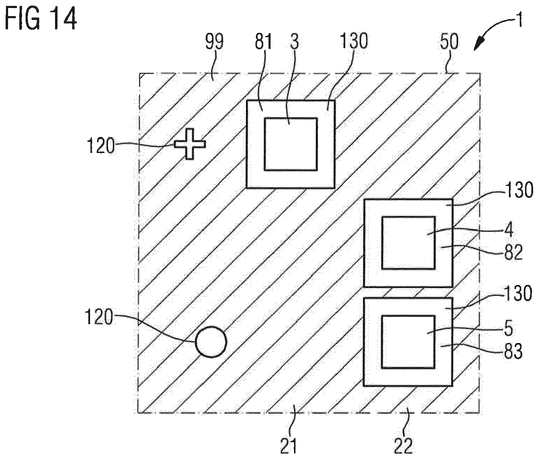

Fig. 14 zeigt eine weitere Ausführungsform, die im Wesentlichen der Figur 13 entspricht, wobei jedoch in dieser Ausführung anstatt der Isolierstege eine Isolierschicht 99 vorgesehen ist. Die Isolierschicht 99 ist auf dem Träger 50, auf den Stromleitungen 21,22, der Umverdrahtungsleiterbahn 110 und der zweiten Durchkontaktierung 26 angeordnet. Über den Kontaktabschnitten 81,82,83 weist die Isolierschicht 99 Öffnungen 130 auf, in denen die Leuchtchips 3,4,5 angeordnet sind. Zudem weist die Isolierschicht 99 beispielsweise Justierstrukturen 120 auf.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Modul (1) für eine Videowand, mit einem Träger (50) mit einer Vielzahl von Bildpixeln (2), wobei ein Bildpixel von wenigstens einem ersten und einem zweiten Leuchtchip gebildet wird, wobei jeder Leuchtchip (3, 4, 5) einen ersten und einen zweiten elektrischen Anschluss (11, 12, 13, 14, 15, 16) aufweist, wobei der erste Leuchtchip (3) eines Bildpixels (2) mit dem ersten elektrischen Anschluss (11) mit einer ersten Stromleitung (21) verbunden ist, wobei der erste Leuchtchip eines Bildpixels (2) mit dem zweiten elektrischen Anschluss (13) mit einer dritten Stromleitung (31) verbunden ist, wobei der zweite Leuchtchip (4) des Bildpixels (2) mit dem ersten elektrischen Anschluss (12) mit einer zweiten Stromleitung (22) verbunden ist, und wobei der zweite Leuchtchip (4) des Bildpixels (2) mit dem zweiten elektrischen Anschluss (14) mit einer vierten Stromleitung (32) verbunden ist, wobei die erste und/oder die zweite Stromleitung (21, 22) in Form einer Flächenmetallisierung ausgeführt sind, wobei die Flächenmetallisierung Kontaktabschnitte (81, 82, 83) aufweist, wobei ein Leuchtchip (3, 4, 5) auf einem Kontaktabschnitt (81, 82, 83) angeordnet ist, wobei wenigstens zwischen Kontaktabschnitten (81, 82, 83) einer ersten und einer zweiten Stromleitung (21, 22) eine Isolierschicht (99) auf dem Träger (50) vorgesehen ist, wobei die Isolierschicht (99) Öffnungen (130) über den Kontaktabschnitten (81,82,83) aufweist, und wobei die Leuchtchips (3, 4, 5) in den Öffnungen (130) angeordnet sind.

2. Modul nach Anspruch 1, wobei die Bildpixel (2) jeweils einen dritten Leuchtchip (5) aufweisen, wobei der dritte Leuchtchip (5) einen ersten und einen zweiten elektrischen Anschluss (15, 16) aufweist, wobei der dritte Leuchtchip (5) mit dem ersten elektrischen Anschluss (15) mit der ersten Stromleitung verbunden ist, und wobei der dritte Leuchtchip (5) mit dem zweiten elektrischen Anschluss (16) mit einer fünften Stromleitung (33) verbunden ist.

3. Modul nach Anspruch 1, wobei die Bildpixel (2) jeweils einen dritten Leuchtchip (5) aufweisen, wobei der dritte Leuchtchip (5) einen ersten und einen zweiten elektrischen Anschluss (15, 16) aufweist, wobei der dritte Leuchtchip (5) mit dem ersten elektrischen Anschluss mit einer sechsten Stromleitung (34) verbunden ist, und wobei der dritte Leuchtchip (5) mit dem zweiten elektrischen Anschluss (16) mit der fünften Stromleitung (33) verbunden ist.

4. Modul nach einem der vorhergehenden Ansprüche, wobei die ersten Stromleitungen (21) und die zweiten Stromleitungen (22) in einer Ebene geführt sind, und wobei die dritten, vierten und fünften Stromleitungen (31, 32, 33) in einer zweiten Ebene geführt sind.

5. Modul nach Anspruch 4, wobei die dritten, vierten und fünften Stromleitungen (31, 32, 33) über Durchkontaktierungen (61, 62, 63) zu einer anderen gemeinsamen Anschlussebene geführt sind als die Ebene wo die erste und die zweite Stromleitungen (21,22) angeordnet sind. sind.

6. Modul nach einem der vorhergehenden Ansprüche, wobei die Leuchtchips (3, 4, 5) in Reihen (51, 52, 53) angeordnet sind, wobei die erste und die zweite Stromleitung (21, 22) an gegenüber liegenden Seiten der Reihen (51, 52, 53) angeordnet sind.

7. Modul nach Anspruch 6, wobei zwischen ersten Stromleitungen (21) zweier benachbarter Reihen (51, 52, 53) von Leuchtchips (3, 4, 5) Durchkontaktierungen (61, 62, 63) vorgesehen sind, um die erste und/oder die zweite und/oder die dritte Stromleitung (21, 22, 31) in eine gemeinsame Anschlussebene zu führen.

8. Modul nach einem der vorhergehenden Ansprüche, wobei der Leuchtchip (3, 4, 5) auf der Seite, die dem Kontaktabschnitt (81, 82, 83) zugewandt ist, eine Abstufung aufweist, so dass der Leuchtchip (3, 4, 5) nicht mit seiner ganzen Seite auf dem Kontaktabschnitt (81, 82, 83) aufliegt.

9. Modul nach einem der vorhergehenden Ansprüche, wobei zwischen den Leuchtchips (3, 4, 5) insbesondere eines Bildpixels (2) wenigstens teilweise Isolierbarrieren (92-99) auf dem Träger (50) angeordnet sind, um eine elektrische Isolierung der Leuchtchips (3, 4, 5) voneinander zu verbessern.

10. Modul nach einem der vorhergehenden Ansprüche, wobei zwischen dem Kontaktabschnitt (81, 82, 83) und dem zugeordneten Leuchtchip (3, 4, 5) ein elektrisch leitender Kontaktfilm (100) angeordnet ist, der den Leuchtchip elektrisch mit dem Kontaktabschnitt (81,82,83) verbindet.

11. Modul nach einem der Ansprüche 8 bis 10, wobei der Leuchtchip (3, 4, 5) mit einer Lotverbindung, insbesondere mit einer AuSn-Lotverbindung, wobei eine Solidustemperatur der Lotverbindung über 260° C liegt, auf den Kontaktabschnitt (81, 82, 83) gelötet ist.

12. Modul nach einem der Ansprüche 8 oder 9, wobei der Leuchtchip (3, 4, 5) mithilfe einer Reibschweißverbindung mit dem Kontaktabschnitt (81, 82, 83) verbunden ist, und/oder wobei der Leuchtchip (3, 4, 5) mithilfe einer Lötung mit dem Kontaktabschnitt (81, 82, 83) verbunden ist.

13. Modul nach einem der Ansprüche 8 bis 12, wobei zwischen Kontaktabschnitten (81, 82, 83) einer ersten und einer zweiten Stromleitung (21, 22) ein Isoliersteg (92-98) vorgesehen ist.

14. Modul nach einem der Ansprüche 8 bis 10, wobei der Leuchtchip (3, 4, 5) mithilfe eines elektrisch isolierenden Klebstoffes auf einem Kontaktabschnitt (81, 82, 83) mechanisch befestigt ist, wobei Spitzen eines metallischen Kontaktes des Leuchtchips (3,4,5) den Klebstoff durchdringen und in elektrischen Kontakt mit dem Kontaktabschnitt (81,82,83) stehen.

15. Modul nach einem der vorhergehenden Ansprüche, wobei wenigstens zwei Leuchtchips (3,4,5) in einer Öffnung (130) der Isolierschicht (99) angeordnet sind.

## Claims

1. Module (1) for a video wall, comprising a carrier (50) comprising a multiplicity of image pixels (2), wherein an image pixel is formed by at least one first and one second light emitting chip, wherein each light emitting chip (3, 4, 5) comprises a first and a second electrical terminal (11, 12, 13, 14, 15, 16), wherein the first light emitting chip (3) of an image pixel (2) is connected to a first power line (21) by the first electrical terminal (11), wherein the first light emitting chip of an image pixel (2) is connected to a third power line (31) by the second electrical terminal (13), wherein the second light emitting chip (4) of the image pixel (2) is connected to a second power line (22) by the first electrical terminal (12), and wherein the second light emitting chip (4) of the image pixel (2) is connected to a fourth power line (32) by the second electrical terminal (14), wherein the first and/or the second power line (21, 22) is/are embodied in the form of a surface metallization, wherein the surface metallization comprises contact sections (81, 82, 83), wherein a light emitting chip (3, 4, 5) is arranged on a contact section (81, 82, 83), wherein at least between contact sections (81, 82, 83) of a first and of a second power line (21, 22) an insulation layer (99) is provided on the carrier (50), wherein the insulation layer (99) comprises openings (130) above the contact sections (81, 82, 83), and wherein the light emitting chips (3, 4, 5) are arranged in the openings (130).

2. Module according to Claim 1, wherein the image pixels (2) each comprise a third light emitting chip (5), wherein the third light emitting chip (5) comprises a first and a second electrical terminal (15, 16), wherein the third light emitting chip (5) is connected to the first power line by the first electrical terminal (15), and wherein the third light emitting chip (5) is connected to a fifth power line (33) by the second electrical terminal (16).

3. Module according to Claim 1, wherein the image pixels (2) each comprise a third light emitting chip (5), wherein the third light emitting chip (5) comprises a first and a second electrical terminal (15, 16), wherein the third light emitting chip (5) is connected to a sixth power line (34) by the first electrical terminal, and wherein the third light emitting chip (5) is connected to the fifth power line (33) by the second electrical terminal (16).

4. Module according to any one of the preceding claims, wherein the first power lines (21) and the second power lines (22) are led in one plane, and wherein the third, fourth and fifth power lines (31, 32, 33) are led in a second plane.

5. Module according to Claim 4, wherein the third, fourth and fifth power lines (31, 32, 33) are led via plated-through holes (61, 62, 63) to a different common connecting plane to the plane where the first and the second power lines (21, 22) are arranged.

6. Module according to any one of the preceding claims, wherein the light emitting chips (3, 4, 5) are arranged in rows (51, 52, 53), wherein the first and the second power line (21, 22) are arranged at opposite sides of the rows (51, 52, 53).

7. Module according to Claim 6, wherein plated-through holes (61, 62, 63) are provided between first power lines (21) of two adjacent rows (51, 52, 53) of light emitting chips (3, 4, 5) in order to lead the first and/or the second and/or the third power line (21, 22, 31) into a common connecting plane.

8. Module according to any one of the preceding claims, wherein the light emitting chip (3, 4, 5) comprises a stepped configuration on the side facing the contact section (81, 82, 83), such that the light emitting chip (3, 4, 5) does not bear by its entire side on the contact section (81, 82, 83).

9. Module according to any one of the preceding claims, wherein between the light emitting chips (3, 4, 5) in particular of an image pixel (2) at least partly insulation barriers (92-99) are arranged on the carrier (50) in order to improve an electrical insulation of the light emitting chips (3, 4, 5) from one another.

10. Module according to any one of the preceding claims, wherein an electrically conductive contact film (100) is arranged between the contact section (81, 82, 83) and the assigned light emitting chip (3, 4, 5), said contact film electrically connecting the light emitting chip to the contact section (81, 82, 83).

11. Module according to any one of Claims 8 to 10, wherein the light emitting chip (3, 4, 5) is soldered onto the contact section (81, 82, 83) by a solder connection, in particular by an AuSn solder connection, wherein a solidus temperature of the solder connection is above 260°C.

12. Module according to either one of Claims 8 and 9, wherein the light emitting chip (3, 4, 5) is connected to the contact section (81, 82, 83) with the aid of a friction welding connection, and/or wherein the light emitting chip (3, 4, 5) is connected to the contact section (81, 82, 83) with the aid of a soldering.

13. Module according to any one of Claims 8 to 12, wherein an insulation web (92-98) is provided between contact sections (81, 82, 83) of a first and of a second power line (21, 22).

14. Module according to any one of Claims 8 to 10, wherein the light emitting chip (3, 4, 5) is mechanically secured on a contact section (81, 82, 83) with the aid of an electrically insulating adhesive, wherein tips of a metallic contact of the light emitting chip (3, 4, 5) penetrate through the adhesive and are in electrical contact with the contact section (81, 82, 83).

15. Module according to any one of the preceding claims, wherein at least two light emitting chips (3, 4, 5) are arranged in an opening (130) of the insulation layer (99) .

## Revendications

1. Module (1) pour un mur vidéo, comprenant un élément porteur (50) pourvu d'une pluralité de pixels d'image (2), un pixel d'image étant formé par au moins une première et une deuxième puce électroluminescente, chaque puce électroluminescente (3, 4, 5) possédant une première et une deuxième borne électrique (11, 12, 13, 14, 15, 16), la première puce électroluminescente (3) d'un pixel d'image (2) étant reliée à la première borne électrique (11) par une première ligne de courant (21), la première puce électroluminescente d'un pixel d'image (2) étant reliée à la deuxième borne électrique (13) par une troisième ligne de courant (31), la deuxième puce électroluminescente (4) du pixel d'image (2) étant reliée à la première borne électrique (12) par une deuxième ligne de courant (22) et la deuxième puce électroluminescente (4) du pixel d'image (2) étant reliée à la deuxième borne électrique (14) par une quatrième ligne de courant (32), la première et/ou la deuxième ligne de courant (21, 22) étant réalisées sous la forme d'une métallisation en surface, la métallisation en surface possédant des portions de contact (81, 82, 83), une puce électroluminescente (3, 4, 5) étant disposée sur une portion de contact (81, 82, 83), une couche isolante (99) se trouvant sur l'élément porteur (50) au moins entre les portions de contact (81, 82, 83) d'une première et d'une deuxième ligne de courant (21, 22), la couche isolante (99) possédant des ouvertures (130) au-dessus des portions de contact (81, 82, 83) et les puces électroluminescentes (3, 4, 5) étant disposées dans les ouvertures (130).

2. Module selon la revendication 1, les pixels d'image (2) possédant respectivement une troisième puce électroluminescente (5), la troisième puce électroluminescente (5) possédant une première et une deuxième borne électrique (15, 16), la troisième puce électroluminescente (5) étant reliée à la première ligne de courant par la première borne électrique (15), et la troisième puce électroluminescente (5) étant reliée à une cinquième ligne de courant (33) par la deuxième borne électrique (16).

3. Module selon la revendication 1, les pixels d'image (2) possédant respectivement une troisième puce électroluminescente (5), la troisième puce électroluminescente (5) possédant une première et une deuxième borne électrique (15, 16), la troisième puce électroluminescente (5) étant reliée à une sixième ligne de courant (34) par la première borne électrique, et la troisième puce électroluminescente (5) étant reliée à la cinquième ligne de courant (33) par la deuxième borne électrique (16).

4. Module selon l'une des revendications précédentes, les premières lignes de courant (21) et les deuxièmes lignes de courant (22) cheminant dans un plan, et les troisièmes, les quatrièmes et les cinquièmes lignes de courant (31, 32, 33) cheminant dans un deuxième plan.

5. Module selon la revendication 4, les troisièmes, quatrièmes et cinquièmes lignes de courant (31, 32, 33) étant acheminées par le biais de contacts traversants (61, 62, 63) vers un plan de raccordement commun différent de celui où se trouvent les première et deuxième lignes de courant (21, 22).

6. Module selon l'une des revendications précédentes, les puces électroluminescentes (3, 4, 5) étant disposées en rangées (51, 52, 53), les première et deuxième lignes de courant (21, 22) étant disposées sur des côtés mutuellement opposés des rangées (51, 52, 53).

7. Module selon la revendication 6, des contacts traversants (61, 62, 63) se trouvant entre les premières lignes de courant (21) de deux rangées (51, 52, 53) de puces électroluminescentes (3, 4, 5) voisines afin d'acheminer la première et/ou la deuxième et/ou la troisième ligne de courant (21, 22, 31) dans un plan de raccordement commun.

8. Module selon l'une des revendications précédentes, la puce électroluminescente (3, 4, 5) possédant une gradation sur le côté qui fait face à la portion de contact (81, 82, 83), de sorte que la puce électroluminescente (3, 4, 5) ne repose pas sur la portion de contact (81, 82, 83) avec la totalité de son côté.

9. Module selon l'une des revendications précédentes, des barrières au moins partiellement isolantes (92 - 99) étant disposées sur l'élément porteur (50) entre les puces électroluminescentes (3, 4, 5) notamment d'un pixel d'image (2) afin d'améliorer une isolation électrique des puces électroluminescentes (3, 4, 5) entre elles.

10. Module selon l'une des revendications précédentes, un film de contact (100) électriquement conducteur étant disposé entre la portion de contact (81, 82, 83) et la puce électroluminescente (3, 4, 5) associée, lequel relie électriquement la puce électroluminescente à la portion de contact (81, 82, 83).

11. Module selon l'une des revendications 8 à 10, la puce électroluminescente (3, 4, 5) étant brasée sur la portion de contact (81, 82, 83) avec une liaison par brasage, notamment avec une liaison par brasage en AuSn, une température de solidus de la liaison par brasage étant supérieure à 260 °C.

12. Module selon l'une des revendications 8 ou 9, la puce électroluminescente (3, 4, 5) étant reliée à la portion de contact (81, 82, 83) à l'aide d'une liaison par soudage par friction et/ou la puce électroluminescente (3, 4, 5) étant reliée à la portion de contact (81, 82, 83) à l'aide d'une brasure.

13. Module selon l'une des revendications 8 à 12, une nervure isolante (92 - 98) se trouvant entre les portions de contact (81, 82, 83) d'une première et d'une deuxième ligne de courant (21, 22).

14. Module selon l'une des revendications 8 à 10, la puce électroluminescente (3, 4, 5) étant fixée mécaniquement sur une portion de contact (81, 82, 83) à l'aide d'un adhésif électriquement isolant, les pointes d'un contact métallique de la puce électroluminescente (3, 4, 5) transperçant l'adhésif et se trouvant en contact électrique avec la portion de contact (81, 82, 83) .

15. Module selon l'une des revendications précédentes, au moins deux puces électroluminescentes (3, 4, 5) étant disposées dans une ouverture (130) de la couche isolante (99).
